Europäisches Patentamt

European Patent Office

Office européen des brevets

(11) Numéro de publication : **0 375 499 B1**

# (12) FASCICULE DE BREVET EUROPEEN

(45) Date de publication du fascicule du brevet :
21.10.92 Bulletin 92/43

(51) Int. Cl.⁵ : **G01V 3/175, G01R 33/26**

(21) Numéro de dépôt : **89403407.3**

(22) Date de dépôt : **08.12.89**

(54) **Procédé de détection magnétique, et dispositif pour la mise en oeuvre de ce procédé.**

(30) Priorité : **20.12.88 FR 8816804**

(43) Date de publication de la demande :
**27.06.90 Bulletin 90/26**

(45) Mention de la délivrance du brevet :
**21.10.92 Bulletin 92/43**

(84) Etats contractants désignés :
**DE GB IT SE**

(56) Documents cités :
**EP-A- 0 140 535**
**EP-A- 0 224 986**
**EP-A- 0 246 146**
**US-A- 3 526 002**
**US-A- 3 786 340**

(73) Titulaire : **THOMSON-CSF**
**51, Esplanade du Général de Gaulle**
**F-92800 Puteaux (FR)**

(72) Inventeur : **Doisy, Martine**
**THOMSON-CSF SCPI Cédex 67**
**F-92045 Paris La Défense (FR)**

(74) Mandataire : **Desperrier, Jean-Louis et al**
**THOMSON-CSF SCPI**
**F-92045 PARIS LA DEFENSE CEDEX 67 (FR)**

EP 0 375 499 B1

## Description

La présente invention se rapporte aux procédés de détection magnétique dans lesquels on transporte, à bord d'un hélicoptère par exemple, des bouées qui sont larguées dans la mer pour transmettre ensuite à cet hélicoptère, par une liaison radio par exemple, les indications de magnétomètres contenus dans ces bouées. Ces indications permettent de déterminer la présence de masses immergées, telles que des sous-marins, qui modifient le champ magnétique terrestre. L'invention se rapporte également aux bouées et aux dispositifs placés dans l'hélicoptère pour mettre en oeuvre le procédé, ainsi qu'à tous les dispositifs qui sont largués à partir d'un véhicule porteur et qui comprennent un magnétomètre sensible.

On connait depuis longtemps, par exemple du brevet US 3,526,002 déposé le 31 mars 1960 par Waddel, des magnétomètres à précession nucléaire qui fonctionnent avec un liquide gyromagnétique tel que le kérosène. Ce liquide est soumis à un champ magnétique par une bobine constituant des moyens d'excitation. Une autre bobine, ou la même, permet ensuite de recueillir le signal désiré. L'ensemble est enfermé dans une bouée largable d'un hélicoptère.

Parmi les magnétomètres les plus sensibles qui peuvent être utilisés dans de tels dispositifs, on connaît en outre, les magnétomètres à résonance magnétique fonctionnant avec des cellules d'hélium pompées optiquement. La demande de brevet européen n° 0 224 986 déposée le 4 août 1986 sous le n° 86305992. 9 décrit ainsi un dispositif qui comprend deux magnétomètres à hélium [3] portés au bout de deux bras fixés à une extrémité du dispositif.

Les magnétomètres à hélium[3] sont eux-mêmes largement connus, par exemple de la demande de brevet d'invention n° 2 104 786 déposée le 15 juillet 1971, ainsi que de la demande de brevet européen 0 246 146 déposée le 7 mai 1987 sous le n° 87401054. 9. Fondamentalement ces magnétomètres comportent une cellule remplie d'hélium lequel est pompé par différents moyens à partir du niveau métastable. Des moyens de mesure permettent de faire précessionner les noyaux ou les atomes d'hélium, selon l'isotope utilisé, autour du champ magnétique à mesurer, et la mesure de la fréquence de précession permet de déterminer la valeur de ce champ magnétique.

On peut utiliser différents moyens de pompage, mais l'un des plus répandus est le pompage optique à partir d'une source de lumière sensiblement monochromatique dont la longueur d'onde est celle de l'émission de l'hélium utilisé entre son niveau métastable $2^{3s}$ et le niveau excité $2^{3p}$. La technique la plus ancienne et la plus simple consiste à utiliser une lampe à décharge elle-même à hélium qui donne naturellement la bonne longueur d'onde, mais on sait utiliser maintenant des lasers accordés sur la bonne fréquence.

L'opération se passe en deux temps. Dans un premier temps on excite la cellule de mesure à l'aide de la source de pompage et l'on arrête cette excitation quand elle a atteint son effet maximum. Dans un deuxième temps on fait précessionner les noyaux ou les atomes d'hélium et l'on mesure la fréquence correspondante, qui détermine la valeur du champ magnétique. Il est tout à fait remarquable de constater que les moments magnétiques nucléaires orientés par le processus de pompage optique conservent cette orientation pendant un temps relativement long, atteignant facilement 10 heures et pouvant dépasser 24 heures.

Les moyens d'excitation de la cellule d'hélium sont d'un encombrement et d'un poids non négligeables par rapport au reste de l'appareillage de mesure et ils consomment une énergie relativement importante, qui nécessite une source d'alimentation elle-même volumineuse et lourde. Si l'on veut pouvoir emmener un nombre suffisant de bouées, dans un hélicoptère par exemple, il faut réduire au maximum la taille et le poids de chacune de ces bouées et ceci conduit souvent à limiter la taille des moyens d'excitation, et donc l'excitation elle-même, ce qui limite la sensibilité et la durée des mesures.

Pour pallier ces inconvénients l'invention propose d'utiliser des moyens d'excitation séparables du reste du magnétomètre, de manière à garder ces moyens d'excitation dans le véhicule porteur et à larguer le reste du magnétomètre avec les dispositifs, le corps de la bouée par exemple, auxquels est associé le magnétomètre.

D'autres particularités et avantages de l'invention apparaîtront clairement dans la description suivante présentée à titre d'exemple non limitatif et faite en regard des figures annexées qui représentent :

-la figure 1, une bouée largable accouplée à des moyens d'excitation ; et

-la figure 2, la bouée de la figure 1 après son largage, et une autre bouée en cours d'accouplement aux moyens d'excitation.

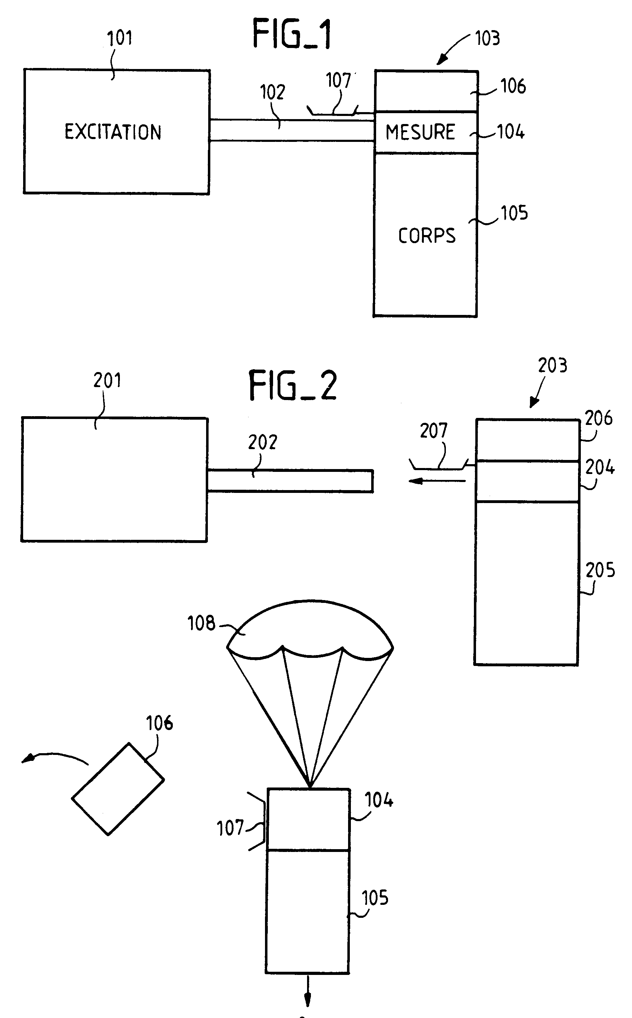

On a représenté sur la figure 1 un dispositif selon l'invention alors qu'il est placé dans un véhicule porteur, un hélicoptère par exemple, lors de la phase d'excitation de la cellule d'hélium.

Ce dispositif comprend des moyens d'excitation 101 comportant par exemple un laser accordé sur la fréquence d'excitation adéquate et des moyens d'alimentation de ce laser.

L'énergie lumineuse provenant des moyens d'excitation 101 est amenée par des moyens de connexion 102 à une bouée largable 103. Ces moyens peuvent être par exemple un faisceau de fibres optiques, ou une optique de collimation délivrant un faisceau lumineux parallèle de dimensions convenables.

Cette bouée largable comprend un corps 105 pouvant contenir des appareils divers, tels que des hydrophones ou une charge explosive par exemple, une tête 106 enfermant des moyens de largage, et un compartiment de mesure 104 qui contient toutes les parties d'un magnétomètre à hélium, à l'exception des moyens d'excitation de la cellule de ce dit magnétomètre.

Lorsque dans une première étape la cellule a été convenablement excitée, dans une seconde étape, représentée schématiquement sur la figure 2, on sépare les moyens d'excitation 101 du compartiment de mesure 104, ce qui entraîne la fermeture d'un volet 107 qui vient obturer l'orifice par lequel les moyens de liaisons 102 étaient reliés au compartiment 104 et la mise en oeuvre de moyens, tels qu'un électro-aimant par exemple, qui appliquent à la cellule un champ magnétique plusieurs fois plus intense que le champ terrestre afin d'éviter que les secousses du largage et de la descente ne désorientent les atomes d'hélium. On largue ensuite la bouée en dehors du véhicule porteur en provoquant l'ouverture de la tête 106. Ceci dégage un parachute 108 qui se déploie et freine la descente de la bouée vers la surface de la mer. Lorsque la bouée vient frapper cette surface, des moyens, connus en eux-mêmes, permettent de la faire flotter, en surface ou éventuellement à une certaine profondeur d'immersion. Ces moyens, qui sont activés par le choc à la surface de l'eau, entraînent également l'arrêt des moyens qui maintiennent les atomes correctement orientés pendant la descente et, de manière connue, la mise en route des différents circuits, en particulier ceux de mesure du champs magnétiques contenus dans le compartiment 104. Les mesures de champ magnétique, ainsi éventuellement que d'autres mesures telles que des mesures acoustiques, sont ensuite transmises, là aussi de manière connue, par des moyens radio-électriques vers une station de réception et d'interprétation, située par exemple dans le véhicule porteur.

Après la séparation entre la bouée et les moyens d'excitation, la place est devenue libre pour raccorder à ces moyens d'excitation une bouée 203 comportant des organes 206 à 207 homologues des organes 106 à 107 de la bouée 103. Lorsque cette bouée 203 est raccordée aux moyens d'excitation, ceux-ci peuvent alors être mis en route pour exciter la cellule à hélium de cette nouvelle bouée, qui sera ensuite larguée comme la première.

Le processus ainsi décrit peut recommencer jusqu'à ce que la provision de bouées contenues dans le véhicule porteur soit épuisée.

L'invention a été décrite dans le cadre d'un magnétomètre à hélium excité par une source d'énergie lumineuse, ce qui correspond à la technique connue du pompage optique. Elle s'étend à tous les dispositifs où on peut isoler le système d'excitation de la cellule sans provoquer de perturbation dans le fonctionnement du magnétomètre.

De même l'invention n'est pas limitée au cas d'une bouée de surveillance passive larguée à partir d'un aéronef, mais elle s'étend à tout dispositif largué à partir d'un véhicule porteur et contenant un magnétomètre à hélium.

## Revendications

1. Procédé de mesure du champ magnétique à l'aide d'un magnétomètre largable du type à hélium, dans lequel on excite une cellule à hélium puis on supprime cette excitation et on mesure la précession des atomes d'hélium sous l'effet du champ magnétique à mesurer, caractérisé en ce que les moyens d'excitation sont liés à un véhicule porteur et les moyens de mesure à un corps largable (105) et qu'après l'étape d'excitation on sépare les moyens d'excitation (101) et les moyens de mesure, on largue le corps largable muni des moyens de mesure (104) pour leur faire rejoindre l'endroit où la mesure doit s'effectuer.

2. Procédé selon la revendication 1, dans lequel on soumet les atomes d'hélium à un champ magnétique intense après l'étape de séparation et avant l'étape de mesure, pour maintenir leur polarisation en dépit des mouvements du magnétomètre.

3. Procédé selon l'une quelconque des revendications 1 et 2, dans lequel l'excitation de la cellule à hélium est faite par pompage optique.

4. Procédé selon la revendication 3, caractérisé en ce que ces moyens d'excitation délivrent une énergie lumineuse sensiblement monochromatique et qu'ils comprennent en outre des moyens de guidage (102) de cette énergie lumineuse vers les moyens de mesure (104).

5. Procédé selon la revendication 4, caractérisé en ce que ces moyens de guidage (102) sont formés par un faisceau de fibres optiques.

6. Procédé selon la revendication 4, caractérisé en ce que ces moyens de guidage (102) sont formés par un dispositif optique de collimation.

7. Dispositif pour la mise en oeuvre du procédé selon l'une quelconque des revendications 1 à 6, caractérisé en ce que les moyens de mesure (104) fixés au corps largable (105), comportent une cellule à hélium et sont aménagés pour pouvoir appliquer à cette cellule l'excitation provenant des moyens d'excitation (101) liés au véhicule porteur.

8. Dispositif selon la revendication 7, caractérisé en ce que les moyens de mesure comportent une ouverture permettant de laisser passer une énergie lumineuse de pompage de la cellule à hélium.

9. Dispositif selon la revendication 8, caractérisé en ce qu'il comporte un volet mobile (107) permettant d'occulter ladite ouverture après la séparation des moyens d'excitation et des moyens de mesure.

10. Dispositif selon l'une quelconque des revendications 7 et 8, caractérisé en ce qu'il forme une bouée (103) largable d'un aéronef et permettant le repérage des corps magnétiques immergés.

**Claims**

1. Method for the measurement of magnetic field using a releasable magnetometer of the helium type, in which a helium cell is excited, this excitation is then suppressed and a measurement is made of the precession of the helium atoms under the effect of the magnetic field to be measured, characterised in that the means of excitation are connected to a carrier vehicle and the means of measurement to a releasable body (105) and in that, after the excitation stage, the means of excitation (101) and the means of measurement are separated, and the releasable body, fitted with the means of measurement (104), is released so as to cause them to join the place where the measurement is to be made.

2. Method according to Claim 1, in which the helium atoms are subjected to a strong magnetic field after the separation stage and before the measurement stage so as to maintain their polarisation in spite of the movements of the magnetometer.

3. Method according to any one of Claims 1 and 2, in which the excitation of the helium cell is achieved by optical pumping.

4. Method according to Claim 3, characterised in that these means of excitation deliver substantially monochromatic light energy and in that they also incorporate means for guidance (102) of this light energy towards the means of measurement (104).

5. Method according to Claim 4, characterised in that these means for guidance (102) are formed by a bundle of optical fibres.

6. Method according to Claim 4, characterised in that these means for guidance (102) are formed by an optical collimating device.

7. Device for the implementation of the method according to any one of Claims 1 to 6, characterised in that the means of measurement (104) fixed to the releasable body (105) comprise a helium cell and are arranged so that they can apply to this cell the excitation originating from the means of excitation (101) connected to the carrier vehicle.

8. Device according to Claim 7, characterised in that the means of measurement comprise an aperture allowing the passage of light energy for pumping the helium cell.

9. Device according to Claim 8, characterised in that it comprises a mobile flap (107) enabling the said aperture to be obstructed after the separation of the means of excitation and the means of measurement.

10. Device according to any one of Claims 7 and 8, characterised in that it forms a buoy (103) which may be released from an aircraft and which enables submerged magnetic bodies to be located.

**Patentansprüche**

1. Verfahren zur Messung des Magnetfelds mit Hilfe eines abwerfbaren Magnetometers vom Heliumtyp, bei welchem man eine Heliumzelle erregt, dann diese Erregung unterdrückt und die Präzession der Heliumatome unter der Wirkung des zu messenden Magnetfelds mißt, dadurch gekennzeichnet, daß die Erregungsmittel mit einem Trägerfahrzeug und die Meßmittel mit einem abwerfbaren Körper (105) verbunden sind und daß man nach der Erregungsstufe die Erregungsmittel (101) und die Meßmittel voneinander trennt und den mit den Meßmitteln (104) versehenen abwerfbaren Körper abwirft, um die Meßmittel an den Ort zu bringen, an dem die Messung erfolgen soll.

2. Verfahren nach Anspruch 1, bei welchem man die Heliumatome nach der Trennungsstufe und vor der Meßstufe einem starken Magnetfeld aussetzt, um ihre Polarisation trotz der Bewegungen des Magnetometers aufrechtzuerhalten.

3. Verfahren nach einem der Ansprüche 1 und 2, bei welchem die Erregung der Heliumzelle durch optisches Pumpen erfolgt.

4. Verfahren nach Anspruch 3, dadurch gekennzeichnet, daß die Erregungsmittel eine im wesentlichen monochromatische Lichtenergie liefern und daß sie außerdem Mittel (102) zur Führung dieser Lichtenergie zu den Meßmitteln (104) aufweisen.

5. Verfahren nach Anspruch 4, dadurch gekennzeichnet, daß die Führungsmittel (102) durch ein optisches Faserbündel gebildet sind.

6. Verfahren nach Anspruch 4, dadurch gekennzeichnet, daß die Führungsmittel (102) durch eine optische Kollimationsvorrichtung gebildet sind.

7. Vorrichtung zur Durchführung des Verfahrens nach einem der Ansprüche 1 bis 6, dadurch gekennzeichnet, daß die an dem abwerfbaren Körper (105) befestigten Meßmittel (104) eine Heliumzelle enthalten und so ausgebildet sind, daß sie auf diese Zelle die Erregung ausüben können, die von den mit dem Trägerfahrzeug verbundenen Erregungsmitteln (101) stammt.

8. Vorrichtung nach Anspruch 7, dadurch gekennzeichnet, daß die Meßmittel eine Öffnung aufweisen, die den Durchgang einer Lichtenergie zum Pumpen der Heliumzelle ermöglicht.

9. Vorrichtung nach Anspruch 8, dadurch gekennzeichnet, daß sie eine bewegliche Klappe (107) aufweist, die das Verschließen der Öffnung nach der Trennung der Erregungsmittel und der Meßmittel ermöglicht.

10. Vorrichtung nach einem der Ansprüche 7 und 8, dadurch gekennzeichnet, daß sie eine Boje (103) bildet, die von einem Luftfahrzeug abwerfbar ist und die Ortung von untergetauchten magnetischen Körpern ermöglicht.

EP 0 375 499 B1

FIG_1

101 EXCITATION

102

107

103

106

MESURE 104

CORPS 105

FIG_2

201

202

203

207

206

204

205

108

106

107 104

105

6